# EUROPEAN PATENT APPLICATION

(11) **EP 2 363 957 A1**
(43) Date of publication of application: **07.09.2011**
(21) Application number: 10305217.1
(22) Date of filing: 04.03.2010
(51) Int. Cl.: H03K 19/177

(54) **Field programmable gate array**

(71) Applicant: Thomson Licensing, 92130 Issy-les-Moulineaux (FR)
(72) Inventor: Blawat, Meinolf, 30659, Hannover (DE); Kropp, Holger, 30900, Wedemark (DE)
(74) Representative: Schmidt-Uhlig, Thomas

(57) **Abstract**

Field programmable gate array having at least one switchable electrical connection between at least two interconnects (2), comprising at least one switching element (10) for providing said switchable electrical connection, wherein the switching element (10) comprises a movable connecting element (16) and a static body (14), and wherein the switchable electrical connection is non-volatile.

## Description

The present invention relates to a field programmable gate array (FPGA) having at least one switchable electrical connection between at least two interconnects. Said FPGA further comprises at least one switching element for providing said switchable electrical connection.

Field-programmable gate arrays (FPGA) are semiconductor devices that can be configured by the customer after manufacturing. FPGAs are programmed using a logic circuit diagram or a source code in a hardware description language (HDL) to specify the functionality of the FPGA. Any logical function that an application-specific integrated circuit (ASIC) could perform, can be implemented. In particular, the ability to update the functionality after shipping is probably the most valuable advantage of an FPGA for many applications. FPGAs contain programmable logic components called logic blocks and a hierarchy of reconfigurable interconnects. Switching elements allow the blocks to be wired together, somehow like a one-chip programmable breadboard. Logic blocks can be configured to perform complex combinational functions or merely simple logic gates like AND and OR. In most FPGAs, the logic blocks also include memory elements, which may be simple flip-flops or more complex blocks of memory.

In nowadays FPGA devices the switching elements are commonly realized using Metal-Oxide-Semiconductor Field Effect Transistors (MOSFETs). Unfortunately, MOSFETs are volatile switches, thus needing a storage cell in order to keep their status, and conduct charge carriers comparable slowly and have relatively high capacity. Both effects lead to a limitation in the processing speed of the FPGA.

In FPGA devices, the logic blocks are connected via programmable routing paths, so called channels. The routing paths are formed out of bunches of parallel wires acting as interconnects. Commonly, interconnects are laid out according to a chessboard pattern. At each connection point of two interconnects a switch box is present, allowing routing each input signal into each output direction. Each switch box comprises a plurality of switching elements providing switchable electrical connections between interconnects.

Since MOSFETs are used as switching elements, the switch box further comprises SRAM cells for storing the current switching status of the switching elements, i.e. the MOSFETs. As a consequence, a switchbox is of high architectural complexity. Further, the switch boxes consume much chip area. Each switch box comprises a plurality of switches and each switch in turn consumes a chip area of seven MOSFETs.

Switching elements in digital circuitry have been identified as a critical component having not progressed as rapidly with respect to miniaturization compared to other components typically comprised by semiconductor devices. As it is known from the disclosure of US 2006/0273871 A1, the use of microelectromechanical switches based on carbon nanotubes leads to smaller switches. However, the aforementioned microelectromechanical switch is technically rather complicated.

It is an object of the present invention to provide a field programmable gate array that is improved with respect to the drawbacks known from prior art.

The problem is solved by the subject matter of independent claim 1, advantageous embodiments are subject matter of the dependent claims.

A field programmable gate array according to the invention has at least one switchable electrical connection between at least two interconnects and further comprises at least one switching element for providing said switchable electrical connection, wherein the switching element comprises a moveable connecting element and a static body, and wherein the switchable electrical connection is non-volatile.

Advantageously, the field programmable gate array (in the following referred to as a FPGA) according to the invention provides an "instant ON" characteristic, i.e. it does not lose its information in case of power down. This is due to the fact that the switching element provides an electrical connection that is non-volatile. Further, the FGPA architecture is significantly simplified. While for known FGPAs a memory cell is necessary for storing the actual switching status of each of the MOSFETs typically used as switching elements, a memory cell is not necessary due to the fact that the switchable electrical connection is non-volatile.

It is further advantageous if the switchable elements define the logic function of the FGPA via their switchable electrical connection. Accordingly, the logic functionality, i.e. the "wiring" of the different blocks of the FGPA, is non-volatile. The respective FPGA does not need to be reconfigured after loss of power, thus it is immediately continuing to function when power is applied.

Advantageously, the movable connecting element and the static body of the switching element are permanently electrically connected. The switching element comprises two parts, i.e. the static body and the movable connecting element. Advantageously, both parts of said switching element form part of an electrical current path, i.e. an electrical current, switchable by the respective switching element, is flowing via both elements of the switching element. Consequently, no further electrically conductive elements, e.g. a metallic switch contact, need to be integrated into the switching element.

Advantageously, the switching element is a telescoping nanotube. An FGPA comprising a switching element based on a telescoping nanotube provides a significantly improved processing speed. This is mainly due to the fact that a telescoping nanotube does not show the typical drawbacks known from MOSFETs, such as low carrier transport speed and high electrical capacity. The carrier transport speed in a MOSFET is limited by the charge carrier mobility in the semiconductor material that is used for the respective MOSFET. In other words, the charge carriers are passing through the conductive channel of the MOSFET too slowly. This phenomenon leads to a limitation in switching time that in turn has been identified to be the main bottleneck for higher processing speeds in FPGAs.

In contrast, a telescoping nanotube, preferably a telescoping nanotube made from carbon nanotubes, conducts charge carriers quite as fast as copper. Further, nanotube switches change their switching status quite faster than common MOSFET based switches. Consequently, the reconfiguration time of the FPGA is significantly reduced, which is in fact a great benefit.

Further, telescoping nanotubes can be manufactured by common CMOS design tools and manufacturing processes. Consequently, the upgrade of existing manufacturing lines is straight forward.

A telescoping nanotube opens the possibility for manufacture of 3D-structures, e.g. 3D-configurable switch boxes, capable of routing signals along x-, y- and z-Axis. By applying such 3D-switching elements, different layers in a chip layout may be electrically connected. Further, a switching element based on a telescoping carbon nanotube takes only a small part of space required by switching elements based on MOSFETs, since each of those switching elements known from prior art consists of a plurality of MOSFETs each having assigned a storage cell, e.g. a SRAM cell, which in turn is typically formed out of six further MOSFETs. Accordingly, the space used for switching elements is significantly reduced.

A further advantageous FGPA comprises an electrical connection point between at least two interconnects, wherein a switching element is integrated between the electrical connection point and each of the interconnects in the vicinity of said connection point. The aforementioned architecture represents the minimal configuration that is necessary for a switchable connection of at least two interconnects. In case two interconnects shall be wired up, only four switching elements are needed. The aforementioned switchable connection allows routing of signals from each interconnect to any other interconnect, provided that the two interconnects meet at the respective connection point.

Alternatively, an FGPA is provided having an electrically insulating cross point between the at least two interconnects, wherein the switchable element is integrated in a section of each of the interconnects in the vicinity of said cross point and a plurality of electrical links is connecting neighboring interconnects. Further, each of said electrical links comprises a switching element. The aforementioned FGPA allows providing more than one electrical link between two of two interconnects via the same cross point. In other words, more than one signal can be routed via the respective cross point; currents routed via the respective cross point can bypass each other.

It is further advantageous if the switchable elements are aligned in a common and preferred orientation, because manufacturing such an FGPA is simplified. The manufacturing process is further simplified if the switchable elements have a movable connecting element, wherein the entire movable connecting elements have a common direction of movement.

For a better understanding the invention shall now be explained in more detail in the following description with reference to the figures. It is understood that the invention is not limited to this exemplary embodiment and that specified features can also expediently be combined and/or modified without departing from the scope of the present invention as defined in the appended claims. In the figures:
- Fig. 1: shows a layout of routing channels,
- Fig. 2: shows a detailed view of a pattern of connection points between the routing channels of Fig. 1,
- Fig. 3: shows a detailed view of a switch box of Fig. 2 having a plurality of switching elements,
- Fig. 4: shows a first switch box,
- Fig. 5: shows a telescoping nanotube in an open state,
- Fig. 6: shows a telescoping nanotube in a closed state,
- Fig. 7: shows a second switch box,
- Fig. 8: shows a third switch box,
- Fig. 9: shows a 3D-arrangement of 3D-switch boxes,
- Fig. 10: shows a first schematic cross section of a 3D-switch box,
- Fig. 11: shows a second schematic cross section of a 3D-switch box, and
- Fig. 12: shows a third schematic cross section of a 3D-switch box.

A field programmable gate array, in the following referred to as an FPGA, comprises a plurality of logic blocks that are connected via programmable routing paths, so called routing channels. A respective routing channel is formed out of a bunch of parallel wires acting as interconnects. At a cross point of routing channels, usually, the respective interconnects are laid out according to a chessboard pattern.

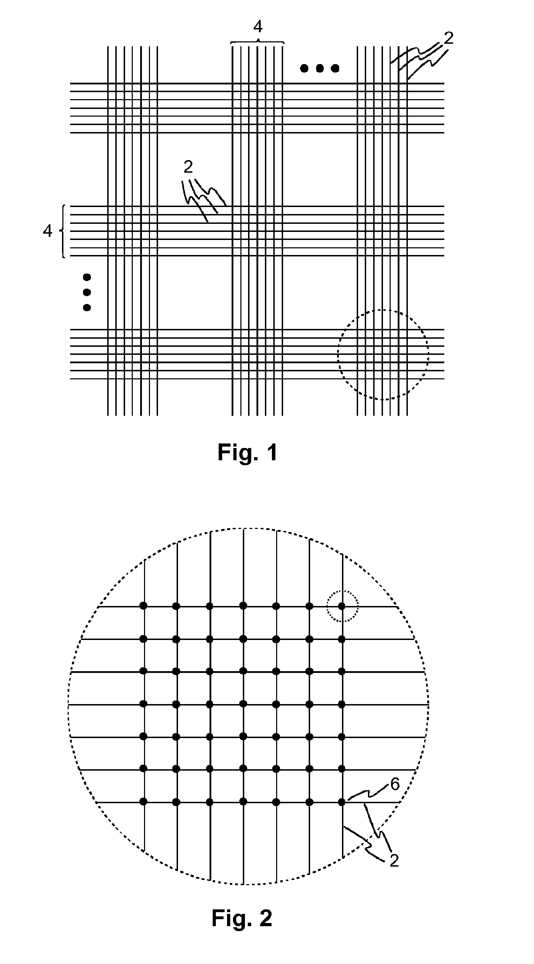

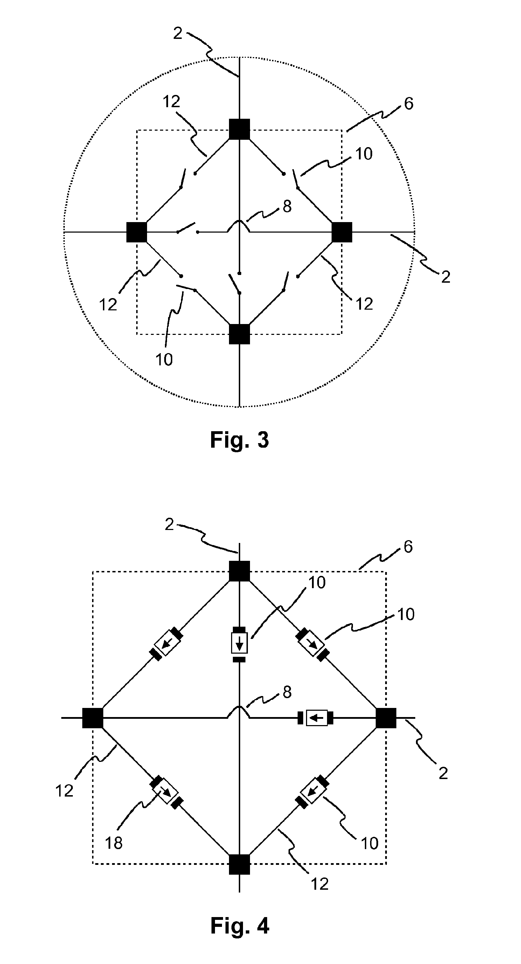

Fig. 1 shows an exemplary layout of routing channels 4, each routing channel 4 comprising a plurality of parallel wires acting as interconnects 2. For the sake of clarity only few of the depicted routing channels 4 and interconnects 2 are given a reference numeral. Fig. 2 shows a detailed view of a typical chessboard pattern at a cross point of two channels 4, known from Fig. 1. At each cross point of two wires 2, a switch box 6 is located. A detailed view of such a switch box 6 is given in Fig. 3. The switch box 6 allows routing an input signal travelling along an arbitrary wire 2 to any output direction different from the input direction. The switch box 6 comprises an insulating cross point 8 between the two wires 2 and a plurality of switching elements 10. Neighboring wires 2 meeting at the insulating cross point 8 are further connected by electrical links 12. Each of said electrical links 12 in turn comprises a switching element 10.

According to a first embodiment of the invention, the switch box 6 known from Fig. 3 is realized applying switching elements 10 based on telescoping nanotubes, as it is shown in Fig. 4. Preferably, carbon nanotubes are applied as telescoping nanotubes. Again, for the sake of clarity only few switching elements 10and electrical links 12 are given a reference numeral.

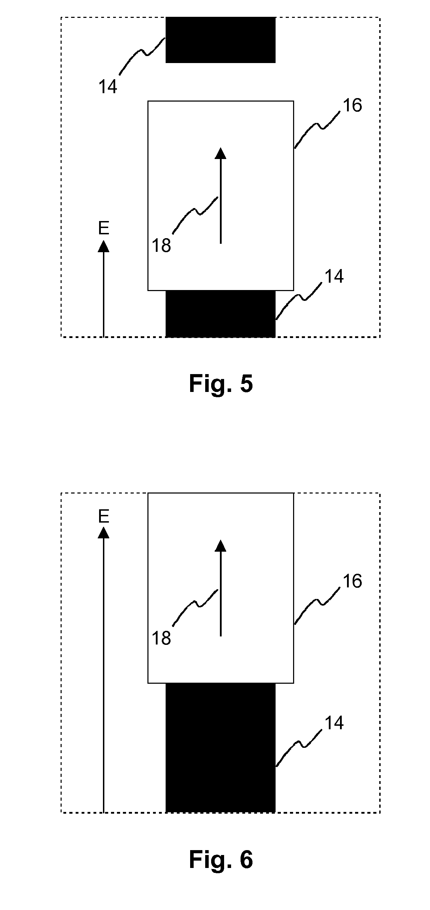

Figs. 5 and 6 exemplarily show a telescoping nanotube in an open and closed state, respectively. The telescoping nanotube comprises a static body 14 and a movable connecting element 16.

Preferably, the movable connecting element 16 is a carbon nanotube having a smaller diameter compared to the static body 14 that in turn is preferably a carbon nanotube and surrounds the movable connecting element 16. The connecting element 16 of the telescoping nanotube slides freely in a direction of movement 18. The telescoping carbon nanotube is switched between an OPEN and CLOSED state by applying an electric voltage between the opposite parts of the static body 14. Due to the applied electric potential, an electric field E is generated thus forcing the connecting element 16 to move in one or the other direction. While Figs. 5 and 6 show the movement of closing the switching element, the polarization of the programming voltage is altered for opening the switching element.

In a closed state of the telescoping nanotube, the switchable current takes a current path via one part of the static body 14 and the connecting element 16 to the opposite part of the static body 14. As it is visible from Fig. 4, the wires acting as interconnects 2, are connected to each part of the static body 14, respectively.

By way of an example, the routing path and the switching position of the switching elements 10 will be explained for an input signal travelling upwards the vertical interconnect 2 in Fig. 4. The output should be to the right in the horizontal interconnect 2. The switching element 10 shown in the lower right part of the switch box 6 is set to a CLOSED state, while the switching elements 10 in the lower left and upper right part are set to an OPEN state. Further, the switching element that is integrated in the horizontal interconnect 2 is set to an OPEN state. The input signal travels up the vertical interconnect, takes the electrical link 12 to the right and is outputted to the horizontal line travelling to the right.

Since the cross point 8 is insulating and the aforementioned signal takes the link 12 in the lower right part of Fig. 4, a further signal may be routed via the switch box 6 shown. By way of an example, an input signal travelling downwards the vertical interconnect 2 can be outputted to the horizontal line travelling to the left via the electrical link 12 in the upper left part of the switch box 6.

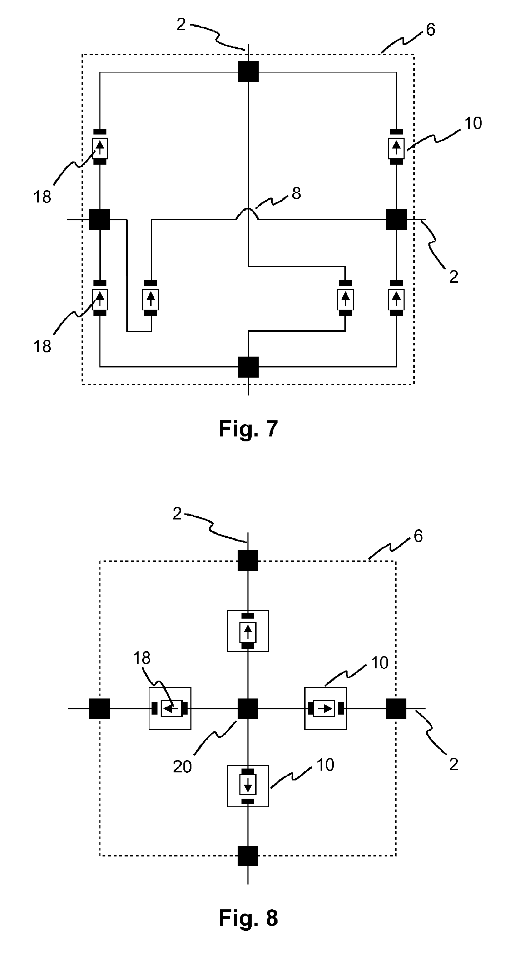

Figs. 7 and 8 show further switch boxes 6. The architecture shown in Fig. 7 provides the same functionality as the switch box 6 depicted in Fig. 4. In contrast to the switch box 6 shown in Fig. 4, all switching elements 10 have a common direction of movement 18. In other words, all the telescoping nanotubes used as switching elements 10 are aligned in a common direction. As a result, the fabrication process of the switch box 6 shown in Fig. 7 and accordingly the fabrication process of an FPGA comprising such a switch box 6 is significantly simplified.

The switch box 6 shown in Fig. 8 has a simplified layout in comparison to the aforementioned switch boxes 6 depicted in Figs. 4 and 7. The switch box 6 according to Fig. 8 has an electrically conductive connection point 20, electrically connecting the horizontal and the vertical interconnect 2. For routing a signal, e.g. travelling upwards the vertical wire 2 to the right in the horizontal wire 2, all four switching elements 10 need to take action. While the two telescoping nanotubes in the lower and right part of the switch box 6 are set to a CLOSED state, the ones in the upper and left part are set to an OPEN state. In contrast to the switch boxes 6 discussed before, the switch box 6 shown in Fig. 8 can only route a single signal.

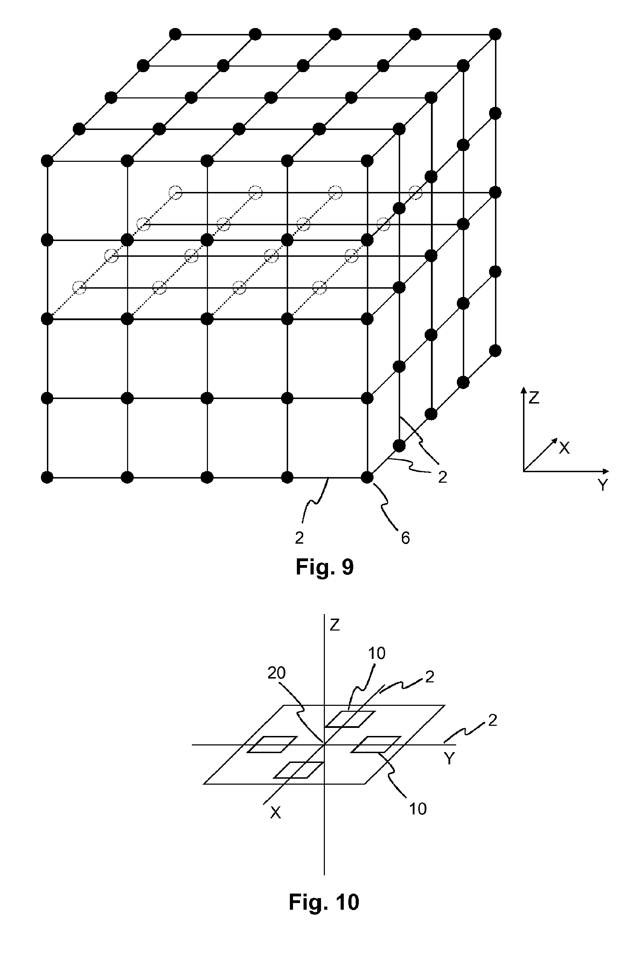

Quite different layouts of switchboxes are possible. For example a multilayer of equally spaced parallel wires can be stacked so that two consecutive wires form a grid of conductors. If more than two layers of parallel connectors are being stacked, a three dimensional arrangement of 3D-switch boxes may be realized, as it is shown in Fig. 9. A number of parallel interconnects 2 are directed in the x⁻, y⁻ and z-direction. At each cross point a 3D-switch box 6 is located, which is able to route a signal in x-, y- and z-direction. Again, for the sake of clarity only few of the interconnects and 3D-switchboxes are given a reference numeral.

The layout of such a 3D-switch box 6 is comparable to the 2D-switch boxes 6 shown in Figs. 4, 7 and 8.

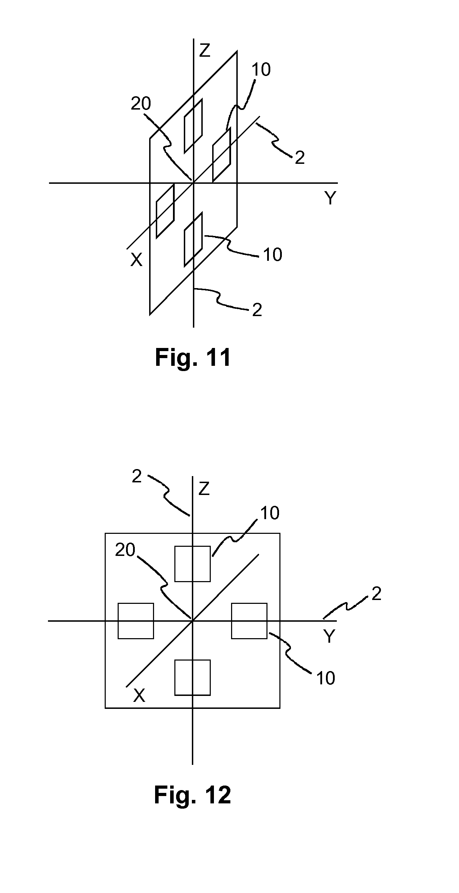

Figs. 10 to 12 each show a cross-sectional view of such a 3D-switch box 6. The layout of this 3D-switch box 6 is similar to the one shown in Fig. 8. Fig. 10 shows a cross-sectional view in the x/y-plane. Two interconnects 2 extending in x- and y-direction are connected at an electrical connection point 20. In the vicinity of said electrical connection point 20, switching elements 10 are integrated in the respective interconnects 2. The four switching elements 10 shown in Fig. 10 allow routing of signals in the x- and y-plane. As it is shown in the Figs. 11 and 12 the 3d-switch box 6 has a similar architecture in the x/z-plane (Fig. 11) and in the x/y-plane (Fig. 12). The 3D-switch box 6 comprises 3x4 switching elements 10 and allows a 3D routing of signals from each input direction into each other output direction.

## Claims

1. Field programmable gate array having at least one switchable electrical connection between at least two interconnects (2), comprising at least one switching element (10) for providing said switchable electrical connection, **characterized in that**
the switching element (10) comprises a movable connecting element (16) and a static body (14), and wherein the switchable electrical connection is non-volatile.

2. Field programmable gate array according to claim 1, **wherein** the switchable elements (10) define the logic function of the field programmable logic array via their switchable electrical connection.

3. Field programmable gate array according to claim 1 or 2, **wherein** the movable connecting element (16) and the static body (14) are permanently electrically connected.

4. Field programmable gate array according to one of claims 1 to 3, **wherein** the switching element (10) is a telescoping nanotube.

5. Field programmable gate array according to one of claims 1 to 4, **wherein** an electrical connection point (20) between the at least two interconnects (2), wherein a switching element (10) is integrated between the electrical connection (20) point and each of the interconnects (2) in the vicinity of said connection point (20).

6. Field programmable gate array according to one of claims 1 to 4, wherein an electrically insulating cross-point (8) between the at least two interconnects (2), wherein a switching element (10) is integrated in a section of each of the interconnects (2) in the vicinity of said cross-point (8), and a plurality of electrical links (12) is connecting neighboring interconnects (2), and wherein each of said electrical links (12) comprises a switching element (10).

7. Field programmable gate array according to one of the preceding claims, **wherein** the switching elements (10) are aligned in a common preferred orientation.

8. Field programmable gate array according to one of the preceding claims, **wherein** the switching elements (10) have a movable connecting element having a common direction of movement (18).
